# FASCICULE DE BREVET EUROPEEN

(11) **EP 0 596 455 B1**
(45) Date de publication et mention de la délivrance du brevet: **31.01.1996**
(21) Numéro de dépôt: 93117739.8
(22) Date de dépôt: 02.11.1993
(51) Int. Cl.: C23C 16/00, H01H 1/00

(54) **Procédé de fabrication d'un élément de microstructure mécanique**
Herstellungsverfahren für mikromechanisches Element
Fabrication method for micromechanical element

(30) Priorité: 04.11.1992 FR 9213352
(43) Date de publication de la demande: 11.05.1994
(73) Titulaire: CSEM, Centre Suisse d'Electronique et de Microtechnique S.A., CH-2007 Neuchâtel (CH)
(72) Inventeur: Moret, Jean-Marc, CH-2016 Cortaillod (CH)
(74) Mandataire: de Montmollin, Henri

(56) Documents cités:
- EP-A- 0 286 337
- US-A- 4 959 515
- US-A- 4 997 521

## Description

L'invention concerne généralement les procédés de fabrication d'un élément de structures micro-mécaniques à partir d'un substrat, notamment en matériau semiconducteur par les techniques de micro-usinage.

Plus particulièrement l'invention concerne un procédé destiné à la fabrication d'un élément de structure de forme générale allongée qui présente au moins une aile de faible épaisseur par rapport à ses autres dimensions et s'étend dans une direction sensiblement perpendiculaire au substrat.

De tels éléments de structure trouvent notamment des applications dans les microstructures mécaniques et particulièrement dans des microstructures telles que des activateurs de tables X/Y ou analogues.

Comme la mécanique classique, la micromécanique utilise des éléments de structure de formes et de sections différentes adaptées aux propriétés mécaniques recherchées dans l'application envisagée.

Un problème particulier se pose toutefois en micromécanique pour la fabrication des éléments de forme généralement allongée tels que les poutres ou analogues.

On a illustré aux figures 1 à 4 les différentes étapes d'un procédé conventionnel utilisé pour fabriquer un élément de structure de forme généralement allongée, en l'occurrence une poutre de section rectangulaire.

Selon ce procédé, on se munit d'un substrat 1 par exemple en un matériau semiconducteur à la surface duquel on forme une couche d'oxyde 2 dite couche sacrificielle (fig 1). On dépose ensuite une couche 4 du matériau qui est destiné à former la poutre 6 et dont l'épaisseur E définit la hauteur de celle-ci (fig 2). La forme et les dimensions dans le plan de la poutre 6 sont alors définies dans la couche 4 par un procédé de photolithographie classique et la couche 4 est gravée selon la forme et les dimensions ainsi définies (fig 3). La partie de la couche 2 se trouvant dans la région de la poutre 6 et sous cette dernière est enfin soumise à une attaque isotrope et sélective pour libérer la poutre 6 (fig 4) qui reste ancrée, au moins à l'une de ses extrémités, au substrat 1.

Il existe de nombreuses microstructures dont le fonctionnement nécessite la réalisation d'éléments de structure présentant au moins une aile de faible épaisseur, relativement à ses autres dimensions et notamment relativement à sa dimension (sa hauteur) qui s'étend selon une direction perpendiculaire au substrat, et présentant ainsi une grande flexibilité selon une direction parallèle au plan du substrat tout en ayant une grande rigidité selon une direction perpendiculaire à ce plan.

En effet, lorsque l'on souhaite, par exemple, fabriquer une structure de suspension pour une table X/Y en polysilicium et qui peut être activée électrostatiquement, telle que celle qui est décrite dans la publication intitulée "Micro Electro Mechanical Systems '92" Travenmünde (Germany), du 4-7 février 1992 de MM V.P.Jaecklin, C. Linder, N.F. de Rooij, J.M.Moret, R. Bischof et F. Rudolf, il est souhaitable, pour améliorer ses caractéristiques de fonctionnement et notamment les forces mises en jeu, de réaliser de longues poutres très étroites dans des couches épaisses. En d'autres termes, si la table s'étend dans un plan X/Y et que les poutres formant sa structure de suspension ont leur largeur, leur longueur et leur hauteur respectivement selon les axes X, Y et Z (l'axe Z étant perpendiculaire au plan X/Y), le rapport de la hauteur à la largeur, désigné généralement par le terme anglais "aspect ratio", doit être aussi grand que possible, de préférence de l'ordre de 10/1 pour une largeur de l'ordre de 0,2µm.

Toutefois, l'aspect ratio que l'on peut obtenir par les procédés classiques tel que celui décrit ci-dessus est de l'ordre de 2/1 pour une largeur minimale d'environ 1µm.

Cet aspect ratio est limité par l'impossibilité pratique de réaliser une gravure complètement anisotrope du matériau de la poutre (gravure uniquement selon l'axe Z et aucune gravure selon les axes X et Y). La gravure sur de grandes hauteurs conduit par conséquent à des poutres dont la section est trapézoïdale et dont les propriétés mécaniques varient le long de la hauteur. Aussi, cela nuit à un fonctionnement optimal de la table en augmentant les contraintes de flexion mises en jeu et donc les tensions nécessaires pour actionner la table.

Par ailleurs, on comprend aisément que même si, en principe, les procédés classiques permettent de réaliser des éléments de structure de section non rectangulaire, telles que des sections en U, en L ou en combinaison de U et de L, au prix d'une très grande complexité de leur mise en oeuvre, ces procédés ne permettent pas compte tenu de ce qui précède, de réaliser des éléments de structure formés de plusieurs ailes de section rectangulaire reliées entre elles avec chacune des ailes ayant une faible épaisseur, par exemple 0,2µm, quelle que soit leur orientation par rapport au plan du substrat.

L'invention a donc pour but principal de remédier aux inconvénients de l'art antérieur susmentionné en fournissant un procédé de fabrication d'un élément de structure pour la micromécanique, notamment d'un élément de structure de forme généralement allongée présentant au moins une aile de faible épaisseur s'étendant selon une direction sensiblement perpendiculaire au substrat, cet élément de structure pouvant présenter des sections de formes très diverses.

A cet effet, l'invention a pour objet un procédé de fabrication d'au moins un élément de structure de forme générale allongée à partir d'un substrat en un premier matériau et présentant une face supérieure sensiblement plane, ledit élément, réalisé en un deuxième matériau, comprenant au moins une première aile parallèle à un plan perpendiculaire à ladite face supérieure, caractérisé en ce qu'il comprend les étapes successives suivantes:
- formation d'une couche sacrificielle sur ladite face supérieure,
- structuration de ladite couche sacrificielle par attaque sélective et directive de celle-ci pour définir au moins une première paroi perpendiculaire à ladite face supérieure,
- dépôt d'une couche dudit deuxième matériau sur la surface de ladite couche sacrificielle structurée,
- attaque sélective et directive de ladite couche dudit deuxième matériau pour laisser au moins la partie de ladite couche deuxième matériau qui s'étend le long de ladite paroi, et
- élimination de ladite couche sacrificielle au moins dans la région de ladite partie de la première couche et sous celle-ci pour former ladite première aile.

Grâce à ce procédé, la largeur de ailes de l'élément de structure est avantageusement définie par l'épaisseur de la première couche et non pas par la lithographie comme dans le cas des procédés de l'art antérieur.

D'autres caractéristiques et avantages de l'invention apparaîtront plus clairement à la lecture de la description suivante du procédé de fabrication de l'invention donné à titre purement illustratif et non limitatif, cette description étant faite en liaison avec le dessin dans lequel:

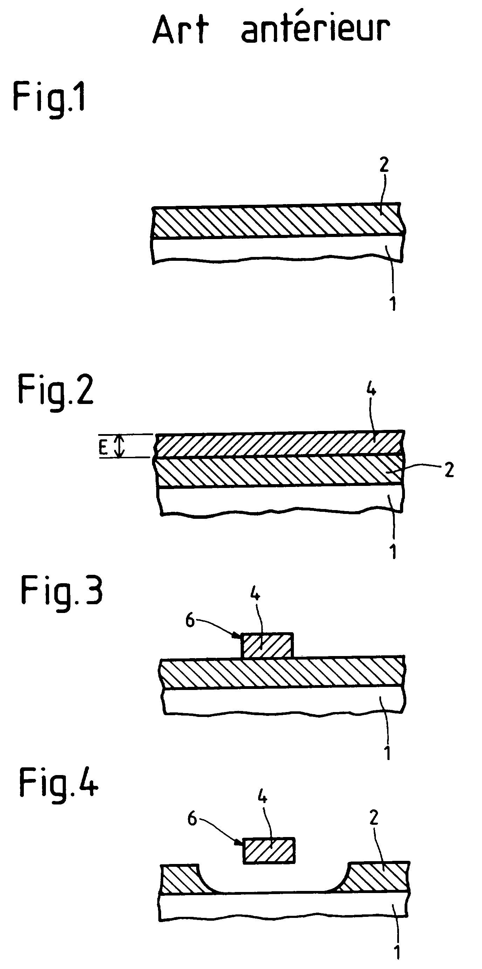

- les figures 1 à 4, déjà mentionnées, sont des vues en coupe d'un élément de structure de forme généralement allongé à partir d'un substrat représenté à différentes étapes d'un procédé de fabrication classique;

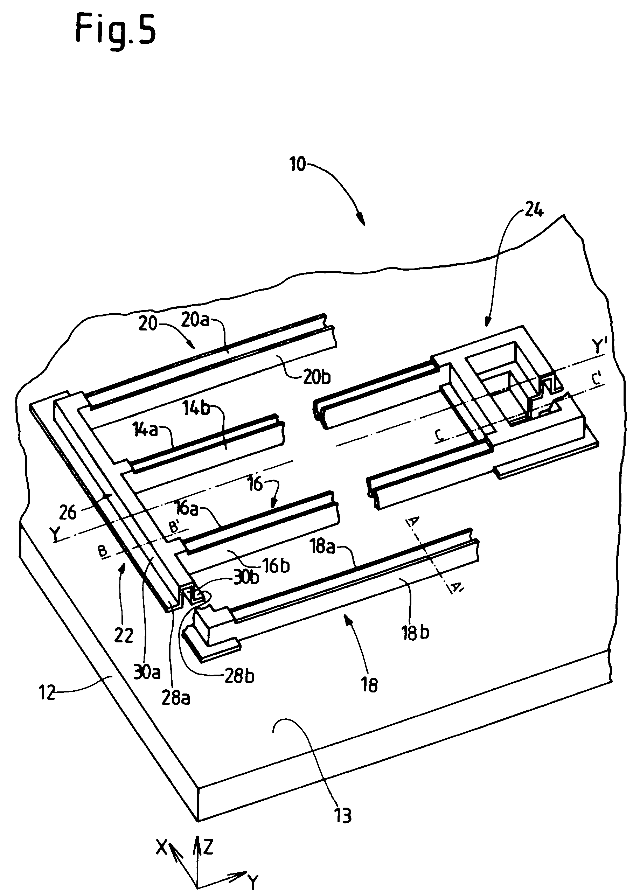

- la figures 5 est une vue partielle en perspective, de moyens de suspension d'une table mobile X/Y réalisés à l'aide d'éléments de structure obtenus selon le procédé de l'invention; et

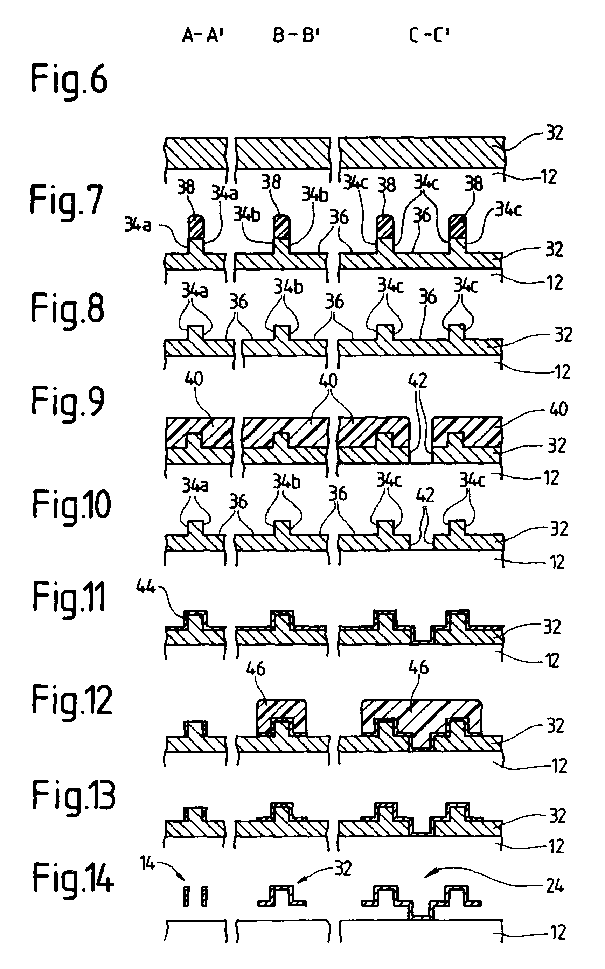

- les figures 6 à 14 sont des vues en coupe selon les lignes A-A', B-B', et C-C' de la figure 5 respectivement d'une première, d'une deuxième et d'une troisième partie des moyens de suspensions représentées à différentes étapes du procédé de fabrication de celles-ci selon l'invention.

La description du procédé de fabrication d'un élément de structure de forme générale allongée qui suit va être faite dans la cadre d'une application de celui-ci à la fabrication d'une micro-structure de suspension d'une table mobile dans un plan X/Y du type de celle décrite dans la référence citée plus haut. Bien entendu, un tel procédé peut trouver de nombreuses autres applications intéressantes, par exemple pour réaliser des miroirs orientables obturateurs optiques, micromanipulateurs.

En outre, bien que les matériaux de base pour réaliser ledit élément de structure selon l'invention soient des matériaux semiconducteurs, il va de soi que d'autres types de matériaux tels que notamment l'aluminium peuvent être également utilisés.

En se référant maintenant à la figure 5, on voit une vue partielle en perspective de la structure de suspension 10 d'une table mobile (non représentée) qui s'étend parallèlement à un plan défini par les axes X/Y. Cette structure 10 comprend une pluralité d'éléments de structure de forme généralement allongée réalisés sur un substrat 12 qui présente une face supérieure 14 généralement plane également parallèlement au plan défini par les axes X/Y.

La structure 10 comprend notamment quatre poutres de flexion 14, 16, 18, et 20 des moyens de liaison 22 rigides des poutres de flexion 14, 16, 18, et 20 ensemble, et des moyens d'ancrage 24 de la structure 10.

Les poutres de flexion 14, 16, 18, et 20 sont formées chacune de deux ailes 14a, 14b, 16a, 16b, 18a, 18b, et 20a, 20b à faces parallèles et ont leur largeur, leur longueur et leur hauteur qui s'étendent respectivement selon les axes X, Y et Z (l'axe Z étant perpendiculaire au plan X/Y). Chaque aile présente une section rectangulaire et un rapport de la hauteur à la largeur supérieure à 5 pour une largeur d'environ 0,2 µm

Toutes les poutres de flexion 14, 16, et 18 sont reliées par une première extrémité aux moyens de liaison 20. Par ailleurs, les deux poutres de flexion centrales 14 et 16 sont reliées par leur deuxième extrémité aux moyens d'ancrage 24 tandis que les poutres extérieures 18 et 20 sont reliées par leur deuxième extrémité à la table mobile (non représentée). La structure 10 est ainsi suspendue au dessus de la face supérieure 13 du substrat 12

Les moyens de liaison 22 sont formés d'une poutre 26 qui présente un profil en U inversé muni de deux ailes latérales 28b reliées chacune à l'extrémité des branches 30a, 30b du U et s'étendant perpendiculairement à celles-ci.

Quant aux moyens d'ancrage 24, ils ont la forme d'un caisson ouvert formé de poutres dont le profil sera décrit en liaison avec le procédé et la figure 14.

On va maintenant décrire les étapes successives du procédé de fabrication, selon l'invention, des différents éléments de structure de forme générale allongée, ou poutres, de la structure de suspension 10 décrite plus haut en référence aux figures 6 à 14.

On notera tout d'abord que compte tenu des faibles dimensions de la structure de suspension, et pour des raisons pratiques que l'on comprend aisément, le procédé de fabrication s'applique à la fabrication simultanée d'un grand nombre de structures de suspension sur une même plaquette définissant le substrat 12.

Par ailleurs, il est important de noter que les valeurs des différents paramètres tels que la température, les temps et les réactifs utilisés etc... décrits dans le procédé ne sont nullement limitatives, et dépendent essentiellement des matériaux utilisés et des appareillages utilisés. Ces valeurs peuvent par conséquent facilement être déterminées par l'homme du métier.

Les plaquettes (non représentées) définissant le substrat 12 sur lesquelles la structure de suspension est construite sont réalisées en un premier matériau ayant les caractéristiques suivantes. Il s'agit de plaquettes de silicium monocristallin d'un type d'orientation et de résistivité quelconque. A ce propos, l'orientation comme la résistivité du silicium du substrat peuvent-être, le cas échéant, déterminées en fonction des caractéristiques d'un circuit intégré réalisé à la surface du même substrat.

En se référant plus particulièrement aux figures 6 à 10 on voit le substrat 12 à différentes étapes successives de sa préparation en vue du dépôt de la couche d'un deuxième matériau (décrit ci-après) qui formera les éléments de structure de forme générale allongée.

A la figure 6, on a représenté le substrat 12 préalablement poli sur au moins sa face supérieure 13 et sur laquelle on a déposé une couche sacrificielle 32 d'oxyde de silicium (SiO₂) De préférence, le SiO₂ est dopé avec 5% de phosphore. En effet ce dopage augmente la vitesse d'attaque du SiO₂ ce qui est très intéressant pour les étapes suivantes de structuration et/ou d'élimination de la couche sacrificielle.

Dans l'exemple décrit, la couche 32 a été déposée par un procédé de dépôt chimique en phase vapeur (CVD) sur une épaisseur d'environ 2 µm et à une température d'environ 425°C. Comme cela ressortira de la suite de la description, l'épaisseur de cette couche détermine la hauteur maximale de l'élément de structure qui pourra être fabriqué, et cette épaisseur peut aisément variée entre 0,5 µm et 3 µm.

Il est bien entendu que, selon une variante, le dépôt de cette couche 32 de SiO₂ peut être réalisé par oxydation du substrat dans un four à une température, pendant un temps et sous une atmosphère appropriés, l'oxydation étant suivie d'une étape de dopage au phosphore par dépôt chimique en phase vapeur (CVD) et d'une étape de diffusion du phosphore dans la couche 32.

A l'étape suivante illustrée aux figures 7 et 8, on procède à la structuration de la couche 32 sur un premier niveau, c'est-à-dire sur une première partie de son épaisseur. En d'autres termes, on définit simultanément une première série de parois perpendiculaires au plan X/Y 34a, 34b, 34c et des surfaces intermédiaires reliant les parois 34a, 34b, 34c deux à deux, qui serviront respectivement, par la suite, à former les ailes 14a, 14b, 16a, 16b, 18a, 18b, 20a. 20b des poutres de flexion les moyens de liaison 22 et une partie des moyens d'ancrage 24 (figure 5).

Pour ce faire, on dépose une première couche de résine photosensible 38, par exemple à la tournette, sur la couche 32, on insole la couche 38 à travers un masque (non représenté), on développe classiquement par voie humide, les parties de la couches 38 insolées, on grave directivement de façon anisotrope les parties de la couche 32 découvertes jusqu'au premier niveau, en l'occurrence sur environ 1µm, pour former les parois 32, puis on élimine les parties de la couche 38 restantes.

L'opération de gravure directive est réalisée, par exemple, au moyen d'un plasma anisotrope CHF₃/C₂F₆/He et l'élimination des parties restantes de la couche 38 est réalisée de façon classique, par exemple, au moyen d'un plasma isotrope O₂.

Aux figures 9 et 10 on a illustré les étapes de structuration de la couche 32 sur un deuxième niveau, ces étapes étant identiques à celles décrites en liaison avec les figures 7 et 8. On précisera tout de même que cette structuration consiste à graver la couche 32 sur une autre partie de son épaisseur à des endroits non protégés par une deuxième couche de résine photosensible 40 préalablement insolée à travers un deuxième masque pour former une deuxième série de parois 42 s'étendant parallèlement à la première série de parois 32. Dans l'exemple décrit, cette structuration comprend notamment la formation de la deuxième série de parois 42 depuis le premier niveau jusqu'au deuxième niveau de l'épaisseur de la couche 38 qui se situe au niveau de la face supérieure 13 du substrat 12.

L'étape suivante illustrée à la figure 11 consiste à déposer une couche 44 du deuxième matériau sur la couche 32 structurée. On notera que dans l'application, la couche 44 est réalisée en silicium polycristallin.

Pour ce faire, on dépose une couche de 0,2µm de silicium polycristallin par LPCVD (dépôt chimique en phase gazeuse à basse pression) à 625°C en présence de SiH₄ O₂ sur la couche 32.

On remarquera que l'épaisseur de cette couche 44 va définir respectivement la largeur des ailes des poutres qui s'étendront perpendiculairement à la face supérieure 13 du substrat 12 et la hauteur des ailes des poutres qui s'étendront parallèlement à cette face supérieure 13.

A l'étape illustrée aux figures 12 et 13, on procède à l'attaque sélective et directive de la couche 44 pour définir la géométrie des éléments de structure que l'on souhaite obtenir c'est-à-dire dans le cas présent, la géométrie des poutres de flexion 14, 16, 18 et 20, la géométrie de la poutre 26 formant les moyens de liaison 22 et des poutres du caisson formant les moyens d'ancrage 24.

A cet effet, on dépose une troisième couche de résine photosensible 46 sur toute la surface de la couche 44, on insole la couche 46 à travers un troisième masque (non représenté), on développe classiquement par voie humide, les parties de la couches 46 insolées, on grave directivement de façon anisotrope les parties de la couche 44 découvertes sur toute l'épaisseur de cette couche 44, en l'occurrence sur environ 0,2µm, puis on élimine les parties de la couche 46 restantes.

L'opération de gravure directive est réalisée, par exemple, au moyen d'un plasma anisotrope CHF₃/C₂F₆/He et l'élimination des parties restantes de la couche 46 est réalisée de façon classique, par exemple au moyen d'un plasma isotrope O₂.

A l'étape suivante, illustrée à la figure 14 on libère tous les éléments de structures définis aux étapes précédente en éliminant la couche sacrificielle 32 au moins dans la région des éléments de structure et sous ceux-ci. L'élimination de la couche 32 est par exemple réalisée par attaque chimique isotrope à l'aide d'une solution d'acide fluoridrique (HF) à 5% et à température ambiante.

## Revendications

1. Procédé de fabrication d'au moins un élément de structure (14) de forme générale allongée sur un substrat (12) en un premier matériau et présentant une face supérieure (13) sensiblement plane, ledit élément (14), réalisé en un deuxième matériau, comprenant au moins une première aile (14a) parallèle à un plan perpendiculaire à ladite face supérieure (13), caractérisé en ce qu'il comprend les étapes successives suivantes:
- formation d'une couche (32) sacrificielle sur ladite face supérieure (13),
- structuration de ladite couche (32) sacrificielle par attaque sélective et directive de celle-ci pour définir au moins une première paroi (34a) perpendiculaire à ladite face supérieure (13),
- dépôt d'une couche (44) dudit deuxième matériau sur la surface de ladite couche (32) sacrificielle structurée,
- attaque sélective et directive de ladite couche (44) dudit deuxième matériau pour laisser au moins la partie de ladite couche (44) dudit deuxième matériau qui s'étend le long de ladite paroi (34a), et
- élimination de ladite couche (32) sacrificielle au moins dans la région de ladite partie de la couche dudit deuxième matériau et sous celle-ci pour former ladite première aile (14a).

2. Procédé selon la revendication 1, caractérisé en ce que l'étape de structuration de ladite couche (32) sacrificielle comprend les étapes successives consistant à:
- déposer une première couche (38) de résine photosensible à la surface de ladite couche (32) sacrificielle,
- insoler ladite première couche (38) de résine photosensible à travers un premier masque,
- développer la partie de ladite première couche (38) photosensible insolée pour découvrir une partie de ladite couche (32) sacrificielle,
- graver directivement ladite partie de ladite couche sacrificielle (32) découverte sur au moins une partie de son épaisseur jusqu'à un premier niveau pour former ladite première paroi (34), et
- éliminer les parties de ladite première couche (38) de résine photosensible restantes.

3. Procédé selon la revendication 2, caractérisé en ce que l'étape d'attaque sélective et directive de ladite couche (44) dudit deuxième matériau comprend, après l'étape consistant à éliminer les parties de ladite première couche (38) de résine photosensible restantes, les étapes successives consistant à:
- déposer une deuxième couche (40) de résine photosensible à la surface de ladite première couche (44) dudit deuxième matériau,
- insoler ladite deuxième couche (40) de résine photosensible à travers un deuxième masque,
- développer et éliminer les parties de ladite deuxième couche (40) photosensible insolées, et en ce que l'étape d'élimination de ladite couche (32) sacrificielle est réalisée par attaque isotrope

4. Procédé selon l'une des revendications précédentes, caractérisé en ce que lesdits premier et deuxième matériaux sont des matériaux semiconducteurs et en ce que ladite couche (32) sacrificielle est réalisée en un oxyde d'un matériau semiconducteur.

5. Procédé selon l'une des revendications précédentes, caractérisé en ce que ladite étape de structuration de ladite couche sacrificielle (32) et ladite étape d'attaque sélective et directive de ladite couche (44) dudit deuxième matériau sont réalisées à l'aide d'un plasma directif.

6. Procédé selon l'une des revendications précédentes, caractérisé en ce que l'étape d'élimination de ladite couche sacrificielle (32) est réalisée par voie humide.

7. Procédé selon l'une des revendications précédentes, caractérisé en ce que l'étape de structuration de ladite couche (32) sacrificielle comporte en outre une étape consistant à définir une deuxième paroi (34a) qui s'étend parallèlement à la première paroi (34a) pour définir une deuxième aile (16a).

8. Procédé selon la revendication 7, caractérisé en ce que l'étape de structuration de ladite couche (32) sacrificielle comprend en outre la formation de ladite deuxième paroi (34a) depuis ledit premier niveau jusqu'à un deuxième niveau de l'épaisseur de ladite couche (32) sacrificielle.

9. Procédé selon la revendication 7, caractérisé en ce que l'étape de structuration de ladite couche (32) sacrificielle comprend en outre la formation de ladite deuxième paroi (34b) également à partir dudit premier niveau de l'épaisseur de ladite couche (32) sacrificielle.

10. Procédé selon la revendication 7 ou 8, caractérisé en ce que l'étape de structuration de ladite couche sacrificielle (32) comprend en outre la formation d'une surface intermédiaire (36) reliant la première (34a) et la deuxième (34b) paroi.

## Patentansprüche

1. Verfahren zum Herstellen mindestens eines Strukturelements (14) generell langgestreckter Form auf einem Substrat (12) aus einem ersten Material und mit einer im wesentlichen ebenen Oberseite (13), wobei das Element (14), hergestellt aus einem zweiten Material, mindestens einen ersten Flügel (14a) parallel zu einer Ebene umfaßt, die senkrecht steht zur Oberseite (13), dadurch gekennzeichnet, daß es die nachstehenden aufeinanderfolgenden Schritte umfaßt:
- Bildung einer Opferschicht (32) auf der Oberseite (13),
- Strukturieren der Opferschicht (32) durch selektiven und gerichteten Angriff auf dieselbe zum Definieren mindestens einer ersten Wandung (34a) senkrecht zu der Oberseite (13),
- Aufbringen einer Schicht (44) des zweiten Materials auf die Oberfläche der strukturierten Opferschicht (32),
- selektiver und gerichteter Angriff der Schicht (44) aus dem zweiten Material, um mindestens die Partie der Schicht (44) des zweiten Materials stehen zu lassen, die sich längs der genannten Wandung (34a) erstreckt, und
- Eliminieren der Opferschicht (32) mindestens im Bereich der Partie der Schicht des zweiten Materials und unter derselben zur Bildung des ersten Flügels (14a).

2. Verfahren nach Anspruch 1, dadurch gekennzeichnet, daß der Schritt der Strukturierung der Opferschicht (32) die aufeinanderfolgenden Schritte umfaßt bestehend aus:
- Aufbringen einer ersten Photoresistschicht (38) auf die Oberfläche der Opferschicht (32),
- Belichten der ersten Photoresistschicht (38) durch eine erste Maske,
- Entwickeln der Partie der belichteten ersten Photoresistschicht (38) zum Freilegen einer Partie der Opferschicht (32),
- direktes Gravieren der freigelegten Partie der Opferschicht (32) auf mindestens einer Partie ihrer Dicke bis zu einem ersten Niveau zum Bilden der ersten Wandung (34), und
- Eliminieren der Partien der ersten Photoresistschicht (38), die verblieben sind.

3. Verfahren nach Anspruch 2, dadurch gekennzeichnet, daß der Schritt des selektiven und direkten Angriffs der Schicht (44) des zweiten Materials nach dem Schritt, der darin besteht, die verbliebenen Partien der ersten Photoresistschicht (38) zu eliminieren, die aufeinanderfolgenden Schritte umfaßt, bestehend aus:
- Aufbringen einer zweiten Photoresistschicht (40) auf die Oberfäche der ersten Schicht (44) aus dem zweiten Material,
- Belichten der zweiten Photoresistschicht (40) durch eine zweite Maske,
- Entwickeln und Eliminieren der belichteten Partien der zweiten Photoresistschicht (40),
und daß der Schritt des Eliminierens der Opferschicht (32) durch isotropen Angriff realisiert wird.

4. Verfahren nach einem der vorangehenden Ansprüche, dadurch gekennzeichnet, daß das erste und das zweite Material halbleitende Materalien sind und daß die Opferschicht (32) aus einem Oxid eines Halbleitermaterials hergestellt ist.

5. Verfahren nach einem der vorangehenden Ansprüche, dadurch gekennzeichnet, daß der Schritt der Strukturierung der Opferschicht (32) und der Schritt des selektiven gerichteten Angriffs der Schicht (44) aus dem zweitem Material mit Hilfe eines gerichteten Plasmas realisiert werden.

6. Verfahren nach einem der vorangehenden Ansprüche, dadurch gekennzeichnet, daß der Schritt des Eliminierens der Opferschicht (32) auf feuchtem Wege realisiert wird.

7. Verfahren nach einem der vorangehenden Ansprüche, dadurch gekennzeichnet, daß der Schritt der Strukturierung der Opferschicht (32) ferner einen Schritt umfaßt bestehend aus der Definition einer zweiten Wandung (34a), die sich parallel zur ersten Wandung (34a) erstreckt, zum Definieren eines zweiten Flügels (16a).

8. Verfahren nach Anspruch 7, dadurch gekennzeichnet, daß der Schritt der Strukturierung der Opferschicht (32) ferner die Bildung der zweiten Wandung (34a) ausgehend vom ersten Niveau bis zu einem zweiten Niveau der Dicke der Opferschicht (32) umfaßt.

9. Verfahren nach Anspruch 7, dadurch gekennzeichnet, daß der Schritt der Strukturierung der Opferschicht (32) ferner die Bildung der zweiten Wandung (34b) umfaßt, ebenfalls ausgehend vom ersten Niveau der Dicke der Opferschicht (32).

10. Verfahren nach Anspruch 7 oder 8, dadurch gekennzeichnet, daß der Schritt der Strukturierung der Opferschicht (32) ferner die Bildung einer Zwischenoberfläche (36) umfaßt, welche die erste (34a) und die zweite (34b) Wandung verbindet.

## Claims

1. Fabrication process of at least one generally elongated structural element (14) on a substrate (12) in a first material and having a substantially flat upper surface (13), said element (14), realized in a second material, comprising at least a first wing (14a) parallel to a plane perpendicular to said upper face (13), characterized in that it comprises the following successive steps :
- forming a sacrificial layer (32) on said upper face (13),
- structuring said sacrificial layer (32) by a selective and directional attack thereof so as to define at least a first wall (34a) perpendicular to said upper face (13),
- depositing a first layer (44) of said second material on the surface of said structured sacrificial layer (32),
- selectively and directionally attacking said layer (44) of said second material so as to leave at least that part of said layer (44) of said second material which extends along said wall (34a), and
- eliminating said sacrificial layer (32) at least in the region of and under said part of the first layer of said second material so as to form said first wing (14a).

2. Process according to claim 1, characterized in that the step of the structuring of said sacrificial layer (32) comprises the successive steps consisting of :
- depositing a first layer (38) of photosensitive resin on the surface of said sacrificial layer (32),
- isolating said first layer (38) of photosensitive resin through a first mask,
- developing the photosensitive isolated, part of said first layer (38) so as to uncover a part of said sacrificial layer (32),
- directionally etching said uncovered part of said sacrificial layer (32) on at least a part of its thickness until a first level so as to form said first wall (34), and
- eliminating the resistant parts of said first layer (38) of photosensitive resin.

3. Process according to claim 2, characterized in that the step of selectively and directionally attacking said layer (44) of said second material comprises, after the step consisting of eliminating the resistant parts of said first layer (38) of photosensitive resin, the successive steps consisting of :
- depositing a second layer (40) of photosensitive resin on the surface of said first layer (44) of said second material,
- isolating said second layer (40) of photosensitive resin through a second mask,
- developing and eliminating the isolated parts of said second photosensitive layer (40), and in that the step of elimination of said sacrificial layer (32) is realized by isotropic attack.

4. Process according to one of the preceding claims, characterized in that said first and second materials are semiconducting materials and in that said sacrificial layer (32) is realized in an oxyde of a semiconducting material.

5. Process according to one of the preceding claims, characterized in that said step of structuring said sacrificial layer (32) and said step of directionally and selectively attacking said layer (44) of said second material are realized with the aid of a directional plasma.

6. Process according to one of the preceding claims, characterized in that the step of elimination of said sacrificial layer (32) is realized by humid path.

7. Process according to one of the preceding claims, characterized in that the step of structuring said sacrificial layer (32) further includes a step consisting of defining a second wall (34a) which extends parallel to the first wall (34a) so as to define a second wing (16a).

8. Process according to claim 7, characterized in that the step of structuring said sacrificial layer (32) further comprises the formation of said second wall (34a) from said first level until a second level of the thickness of said sacrificial layer (32).

9. Process according to claim 7, characterized in that the step of structuration of said sacrificial layer (32) further comprises the formation of said second wall (34b) from said first level of the thickness of said sacrificial layer (32).

10. Process according to claim 7 or 8, characterized in that the step of structuring said sacrificial layer (32) further comprises the formation of an intermediate surface (36) connecting the first (34a) and the second (34b) wall.
